# EUROPEAN PATENT APPLICATION

(11) **EP 2 949 720 A1**
(43) Date of publication of application: **02.12.2015**
(21) Application number: 14742845.2
(22) Date of filing: 16.01.2014
(51) Int. Cl.: C09J 201/00, C09J 7/00, C09J 11/04, C09J 11/06, C09J 11/08, G02B 5/02, H05B 33/02, H05B 33/14

(54) **OPTICAL-MEMBER ADHESIVE COMPOSITION, OPTICAL-MEMBER ADHESIVE LAYER, AND SURFACE LIGHT SOURCE DEVICE**

(30) Priority: 25.01.2013 JP 2013012259; 27.03.2013 JP 2013067095
(71) Applicant: Zeon Corporation, Tokyo 100-8246 (JP)
(72) Inventor: MASHIMA, Hiromu, Tokyo 100-8246 (JP); HARAI, Kenichi, Tokyo 100-8246 (JP)
(74) Representative: Vossius & Partner Patentanwälte Rechtsanwälte mbB
(86) International application number: PCT/JP2014/050717
(87) International publication number: WO 2014/115639

(57) **Abstract**

An optical-member adhesive composition, including an adhesive material, reactive modified metal oxide particles having a volume average particle diameter of 1 to 500 nm, and organic light diffusing particles, and optionally including a silane coupling agent and a plasticizer; an optical-member adhesive layer formed from the optical-member adhesive composition; and a surface light source device including the specific light diffusion layer.

## Description

### Field

The present invention relates to an adhesive composition for an optical member and an adhesive layer for an optical member, and more particularly to an adhesive composition for an optical-member and an adhesive layer for an optical member that can be suitably used for applications requiring high refractive index. The present invention further relates to a surface light source device including an organic electroluminescence (referred to hereinbelow as an "organic EL") element.

### Background

When optical devices are configured by combination of a plurality of optical members, these optical members may have to be bonded with an adhesive. Such an adhesive layer may have to have high light diffusivity and a high refractive index.

For example, organic electroluminescence elements (may be simply referred to hereinbelow as "organic EL elements") including, as an optical member, an organic luminescent layer between electrode layers to cause electrical luminescence have been studied for use as display elements in place of liquid crystal cells. In addition, organic EL elements have also been studied for use as surface light source devices, such as flat lighting devices and backlights for liquid crystal display apparatuses, taking advantage of characteristics such as high luminous efficiency, low voltage drive, light weight, and low cost.

The use of an organic EL element as a light source for surface light source devices involves a challenge for efficient extraction of light in a useful form from the element. For example, although a luminescent layer in an organic EL element itself has high luminous efficiency, the amount of light is decreased by, e.g., interference in the layers during the light passes through the layered structure constituting the element until light emission. Therefore, there is a need for reducing such loss of light as low as possible.

In a production of a surface light source device including an organic EL element, a structure including the organic EL element and a light extraction film (film having a surface structure for increasing light extraction efficiency) are often bonded via an adhesive layer. Light generated in the organic EL element of such a surface light source device passes through the adhesive layer and the light extraction film and then goes out of the device. When the adhesive layer in such a surface light source device has high light diffusivity and a high refractive index, it is particularly advantageous for increasing light extraction efficiency.

There are known adhesive compositions containing, in addition to adhesive compositions exhibiting adhesiveness, metal oxides for achieving high refractive index (for example, Patent Literatures 1 to 3).

Furthermore, as a measure for improving light extraction efficiency, there is known provision of a variety of structures at a location closer to a light extraction surface than a light source device. For example, Patent Literature 4 has proposed to provide a variety of structures at a location closer to a light extraction surface than a light source device.

### Citation List

### Patent Literature

Patent Literature 1: Japanese Patent Application Laid-Open No. 2010-254889 A
Patent Literature 2: Japanese Patent Application Laid-Open No. 2008-106129 A
Patent Literature 3: Japanese Patent Application Laid-Open No. 2010-095392 A
Patent Literature 4: Japanese Patent Application Laid-Open No. 2009-266429 A

### Summary

### Technical Problem

However, the adhesive compositions disclosed in Patent Literatures 1 to 3 all have low light diffusivity.

As considerable means for increasing the light diffusivity of such adhesive compositions, light diffusing particles may be further added. The addition of light diffusing particles, however, tends to cause precipitation of the light diffusing particles in the process for producing an adhesive composition, which makes it difficult to produce a homogeneous adhesive composition that can stably exhibit adhesiveness.

Therefore, an object of the present invention is to provide an adhesive composition and an adhesive layer that has high light diffusivity and a high refractive index, and can be produced in a homogeneous state with an ability to stably exhibit adhesiveness.

Furthermore, surface light source devices are also required to have reduced change in color tone depending on the observation angle, in addition to high light extraction efficiency. The structure provided for increasing light extraction efficiency as disclosed in Patent Literature 4 may increase change in color tone depending on the observation angle. Therefore, it has been difficult to obtain a surface light source device that satisfies all of these requirements.

Another object of the present invention is to provide a surface light source device that attains both high light extraction efficiency and small change in color tone depending on the observation angle on the light exiting surface.

### Solution to Problem

The present inventors have studied to solve the aforementioned problems and, as a result, have found out that the aforementioned problems can be solved by employing a certain metal oxide and light diffusing particles. The present inventors also have found out that the aforementioned problems can be solved by providing a light diffusion layer on the surface of a substrate of an organic EL element, wherein the light diffusion layer contains light diffusing particles and has a specific scattering anisotropy coefficient g and other specific properties. The present inventors have completed the present invention on the basis of such findings.

Specifically, according to the present invention, the followings [1] to [8] are provided.
(1) An optical-member adhesive composition, comprising an adhesive material, reactive modified metal oxide particles having a volume average particle diameter of 1 to 500 nm, and organic light diffusing particles.
(2) The optical-member adhesive composition according to (1), further comprising a silane coupling agent.
(3) The optical-member adhesive composition according to (1) or (2), further comprising a plasticizer.
(4) An optical-member adhesive layer formed from the optical-member adhesive composition according to any one of (1) to (3).
(5) A surface light source device, comprising:
   an organic electroluminescence element including a luminescent layer;
   a light-transmissive substrate closer to a light exiting surface than the organic electroluminescence element; and
   a light diffusion layer provided on a surface of the light-transmissive substrate, the surface being opposite to a surface where the organic electroluminescent element is provided, wherein
   the light diffusion layer includes a light-transmissive resin and light diffusing particles, the light diffusion layer has a scattering anisotropy coefficient g of 0.83 or more and 0.97 or less, and the light diffusion layer and the light-transmissive substrate have a refractive index difference of 0.1 or less.
(6) The surface light source device according to (5), wherein the light diffusion layer is a diffusion adhesive layer.
(7) The surface light source device according to (5) or (6), wherein the light diffusing particles have a volume average particle diameter of 0.4 to 5 µm.
(8) The surface light source device according to any one of (5) to (7), wherein
   the light diffusion layer is formed from an optical-member adhesive composition; and
   the optical-member adhesive composition contains an adhesive material as the light-transmissive resin and organic light diffusing particles as the light diffusing particles, and further contains reactive modified metal oxide particles having a volume average particle diameter of 1 to 500 nm.

### Advantageous Effects of Invention

The optical-member adhesive composition and the adhesive layer of the present invention can be produced as homogeneous products capable of stably exhibiting adhesiveness while having high light diffusivity by virtue of the light diffusing particles and a high refractive index by virtue of the reactive modified metal oxide particles. The surface light source device of the present invention attains both high light extraction efficiency and small change in color tone depending on the observation angle on the light exiting surface.

### Brief Description of Drawings

FIG. 1 is a cross-sectional view schematically showing a first embodiment as an example of a surface light source device of the present invention.
Fig. 2 is a perspective view schematically showing a second embodiment as another example of the surface light source device of the present invention.
Fig. 3 is a graph showing the luminous intensity distribution of the tristimulus values (X, Y, Z) on the light emitting surface, which is set as the simulation conditions in Examples in the present application.

### Description of Embodiments

The present invention will be described hereinbelow in detail by way of embodiments and illustrations. However the present invention is not limited to the following embodiments and the illustrations, and may be optionally modified and practiced without departing from the scope of the claims and equivalents thereto.

In the following description, components being "parallel" or "perpendicular" may include an error in a range without impairing the effects of the present invention, e.g. ± 5°, unless otherwise specified. Also, "along" a certain direction means being "parallel" to a certain direction, unless otherwise specified. Furthermore, unless otherwise specified, the thickness direction of each layer constituting a luminescence element corresponds to the thickness direction of the luminescence element, and what is simply referred to as "thickness direction" is the thickness direction of a luminescence element.

As used herein, the term "solvent" includes not only a medium that constitutes a solution in which solutes are dissolved, but also a medium that constitutes a suspension (including a slurry) in which dispersion materials are dispersed.

### [1. Adhesive Composition]

The adhesive composition of the present invention contains an adhesive material, specific reactive modified metal oxide particles, and organic light diffusing particles.

### [1. 1. Adhesive Material]

The adhesive material is a material allowing the adhesive composition of the present invention to exhibit the adhesiveness. In the adhesive composition, the adhesive material is usually present in a liquid state or in the state of being dissolved in other ingredients.

As the adhesive material, a variety of materials having adhesiveness used for optical materials may be used. Examples of such adhesive materials may include polymers and other polymer compounds that are used as main ingredients of a variety of adhesives. Examples of such adhesives may include rubber-based adhesives, acrylic-based adhesives, silicone-based adhesives, urethane-based adhesives, vinyl alkyl ether-based adhesives, polyvinyl alcohol-based adhesives, polyvinylpyrrolidone-based adhesives, polyacrylamide-based adhesives, and cellulose-based adhesives. Of these, preferable as the adhesive material are acrylic polymers that are main ingredients in acrylic-based adhesives having excellent properties such as transparency, weather resistance, and thermal resistance.

### [1. 1. 1. Acrylic Polymer]

Acrylic polymers are polymers formed by polymerization of acrylic monomers, or polymers formed by polymerization of mixtures of acrylic monomers and monomers copolymerizable therewith (monomer mixtures) and including units derived from such monomers.

Examples of acrylic monomers may include alkyl (meth)acrylates. As used herein, (meth)acrylates mean acrylates, methacrylates, and mixtures thereof. The average carbon number of the alkyl group of alkyl (meth)acrylates is preferably about 1 to 12, and more preferably 3 to 8. Specific examples of alkyl (meth)acrylates may include methyl (meth)acrylate, ethyl (meth)acrylate, butyl (meth)acrylate, 2-ethylhexyl (meth)acrylate, and isooctyl (meth)acrylate. As the alkyl (meth)acrylate, one type thereof may be solely used, and two or more types thereof may also be used in combination.

Preferable examples of the monomers copolymerizable with acrylic monomers, which may be contained in the monomer mixtures, may include monomers having functional groups (those may be simply referred to hereinbelow as "functional group-containing monomers"), nitrogen atom-containing monomers, and modification monomers.

Examples of the functional group-containing monomers may include carboxyl group-containing monomers, hydroxyl group-containing monomers, and epoxy group-containing monomers. Examples of the carboxyl group-containing monomers may include acrylic acid, methacrylic acid, fumaric acid, maleic acid, and itaconic acid. Examples of the hydroxyl group-containing monomers may include 2-hydroxyethyl (meth)acrylate, hydroxybutyl (meth)acrylate, hydroxyhexyl (meth)acrylate, and N-methylol (meth)acrylamide. Examples of the epoxy group-containing monomers may include glycidyl (meth)acrylate. When the monomer mixture contains a functional group-containing monomer, the ratio of monomers is preferably as follows: 60 to 99.8% by weight of an acrylic monomer and 40 to 0.2% by weight of the functional group-containing monomer with respect to 100% by weight of the total of the monomer mixture.

Examples of the nitrogen atom-containing monomers may include (meth)acrylamide, N,N-dimethyl (meth)acrylamide, N,N-diethyl (meth)acrylamide, (meth)acryloyl morpholine, (meth)acetonitrile, vinylpyrrolidone, N-cyclohexylmaleimide, itaconimide, and N,N-dimethylaminoethyl (meth)acrylamide. When the monomer mixture contains a nitrogen atom-containing monomer, the ratio of monomers is preferably as follows: 60 to 99.8% by weight of an acrylic monomer and 40 to 0.2% by weight of the nitrogen atom-containing monomer with respect to 100% by weight of the total of the monomer mixture.

Examples of the modification monomers may include vinyl acetate and styrene. When the monomer mixture contains a modification monomer, the ratio of monomers is preferably as follows: 60 to 99.8% by weight of an acrylic monomer and 40 to 0.2% by weight of the modification monomer with respect to 100% by weight of the total of the monomer mixture.

As the monomer copolymerizable with an acrylic monomer, one type thereof may be solely used, and two or more types thereof may also be used in combination.

As the adhesive material, commercially available adhesives as they are may also be used. The commercially available adhesives may contain solvents, additives, and others. They may be used as a material for the adhesive composition of the present invention in the state of containing such ingredients. Examples of commercially available adhesives containing acrylic polymers may include trade name "X-311033S" (manufactured by Saiden Chemical Industry Co., Ltd., solvent: ethyl acetate, solid content ratio 35%).

The content ratio of the adhesive material in the adhesive composition of the present invention is preferably 10% by weight or more and more preferably 20% by weight or more, and is preferably 80% by weight or less and more preferably 70% by weight or less, with respect to the total amount of the adhesive composition.

### [1. 2. Reactive Modified Metal Oxide Particles]

The reactive modified metal oxide particles are particles containing a metal oxide and an organic substance having a reactive functional group modifying the surface of the metal oxide. More specifically, the reactive modified metal oxide are coated particles containing metal oxide particles and an organic substance having a reactive functional group modifying the surface of the metal oxide particles.

In the reactive modified metal oxide, the reactive functional group may be in a state of interaction with the metal oxide through hydrogen bonding or the like. Alternatively, the reactive functional group may be not in such a state but in a state of interaction with another substance.

Examples of the reactive functional group in the organic substance having the reactive functional group may include a hydroxyl group, a phosphate group, a carboxyl group, an amino group, an alkoxy group, an isocyanate group, acid halides, acid anhydrides, a glycidyl group, a chlorosilane group, and an alkoxysilane group.
Particularly preferable organic substances having the reactive functional group are organic substances having an isocyanate group since they can improve stability of the metal oxide and the surrounding substance.

Examples of organic substances having an isocyanate group may include acryloxymethyl isocyanate, methacryloxymethyl isocyanate, acryloxyethyl isocyanate, methacryloxyethyl isocyanate, acryloxypropyl isocyanate, methacryloxypropyl isocyanate, and 1,1-bis(acryloxymethyl)ethyl isocyanate.

Examples of metal oxide species constituting the reactive modified metal oxide may include titanium oxide, zinc oxide, zirconium oxide, antimony oxide, tin-doped indium oxide (ITO), antimony-doped tin oxide (ATO), fluorine-doped tin oxide (FTO), phosphorus-doped tin oxide (PTO), antimony zinc oxide (AZO), indium-doped zinc oxide (IZO), aluminum-doped zinc oxide, gallium-doped zinc oxide, cerium oxide, aluminum oxide, and tin oxide.

The volume average particle diameter of the reactive modified metal oxide particles used in the present invention is from 1 to 500 nm. The particle diameter is preferably 3 nm or larger and more preferably 5 nm or larger, and is preferably 100 nm or smaller and more preferably 50 nm or smaller. By having particle diameter of not more than the upper limit, an adhesive layer having a high light transmittance and less coloring can be obtained, and dispersion of the particles can be facilitated. When the reactive modified metal oxide aggregates to form secondary particles or higher-order particles, the range of the particle diameter may be the range of the primary particle diameter. The particle diameter may be measured as the volume-based particle diameter using a dynamic light scattering particle size distribution analyzer (Nanotrac Wave-EX150 manufactured by Nikkiso Co., Ltd.).

In the reactive modified metal oxide particles, the content ratio of the organic substance having the reactive functional group may be 1 to 40 parts by weight with respect to 100 parts by weight of the metal oxide.

The reactive modified metal oxide particles according to the present invention may be obtained as a suspension by mixing metal oxide particles, an organic substance having a reactive functional group, an organic solvent, and, if necessary, optional additives, and if necessary subjecting the resulting mixture to a treatment such as ultrasonic treatment. The resulting suspension may be obtained in the state where the particles are dispersed in the organic solvent.

Examples of organic solvents may include ketones, such as methyl ethyl ketone, methyl isobutyl ketone, acetone, and cyclohexanone; aromatic hydrocarbons, such as benzene, toluene, xylene, and ethylbenzene; alcohols, such as methanol, ethanol, isopropyl alcohol, n-butanol, and isobutanol; ethers, such as ethylene glycol monomethyl ether, ethylene glycol monoethyl ether, ethylene glycol monobutyl ether, diethylene glycol monomethyl ether, and diethylene glycol monoethyl ether; esters, such as ethyl acetate, butyl acetate, ethyl lactate, γ-butyrolactone, propylene glycol monomethyl ether acetate, and propylene glycol monoethyl ether acetate; and amides, such as dimethylformamide, N,N-dimethylacetoacetamide, and N-methylpyrrolidone. As the organic solvent, one type thereof may be solely used, and two or more types thereof may also be used as a mixture.

Examples of optional additives that may be added to the mixture may include metal chelating agents.

When the reactive modified metal oxide particles are obtained as a suspension in which the particles are dispersed in the organic solvent, it is preferable to obtain a suspension containing 1 to 50% by weight of the reactive modified metal oxide particles by controlling the conditions such as the amount of the solvent. Such a suspension as it is may be subjected to the production of the adhesive composition to achieve simple production.

In the preparation of the mixture, the ingredients are preferably mixed with a bead mill or the like. Such mixing can break up secondary particles or higher-order particles into the level of primary particles and accordingly allows surface treatment on the primary particles, resulting in uniform surface treatment.

If necessary, the mixture may further be subjected to ultrasonic treatment. Ultrasonic treatment may be performed using a device, such as an ultrasonic cleaning machine, an ultrasonic homogenizer, and an ultrasonic disperser. Such ultrasonic treatment can give a favorable suspension.

As the reactive modified metal oxide particles, commercially available particles as they are may also be used. The commercially available particles may be provided as slurries containing ingredients such as solvents and additives. The slurries as they are containing such ingredients may be used as the material for the adhesive composition of the present invention. Examples of slurries of reactive modified metal oxide particles containing ZrO₂ as a metal oxide may include trade name "ZR-010" (manufactured by Solar Co., Ltd.; solvent: methyl ethyl ketone, particle content ratio 30%; organic substance having a reactive functional group modifying the surface: isocyanate having a polymerizable functional group; volume average particle diameter 15 nm). Examples of slurries of reactive modified metal oxide particles containing TiO₂ as a metal oxide may include trade name "NOD-742 GTF" (manufactured by Nagase chemteX Corporation; solvent: polyethylene glycol monomethyl ether, particle content ratio 30%; volume average particle diameter 48 nm).

The content ratio of the reactive modified metal oxide particles in the adhesive composition of the present invention is preferably 30% by weight or more and more preferably 40% by weight or more, and is preferably 80% by weight or less and more preferably 70% by weight or less, with respect to the total amount of the adhesive composition.

### [1. 3. Organic Light Diffusing Particles]

Examples of organic materials constituting the organic light diffusing particles may include silicone resins, acrylic resins, and polystyrene resins. The volume average particle diameter of the organic light diffusing particles is preferably 0.2 µm or larger, more preferably 0.4 µm or larger, and still more preferably 0.5 µm or larger, and is preferably 5 µm or smaller, and more preferably 3 µm or smaller.

Examples of commercially available organic light diffusing particles made of silicone resin may include trade name "XC-99" (manufactured by Momentive Performance Materials Inc.; volume average particle diameter 0.7 µm). Examples of commercially available organic light diffusing particles made of acrylic resin may include trade name "MP series" (manufactured by Soken Chemical & Engineering Co., Ltd.; volume average particle diameter 0.8 µm). Examples of commercially available organic light diffusing particles made of polystyrene resin may include trade name "SX series" (manufactured by Soken Chemical & Engineering Co., Ltd.; volume average particle diameter 3.5 µm).

Use of such organic light diffusing particles as the light diffusing particles imparts a significant effect such that the adhesive composition of the present invention can have high light diffusivity and a high refractive index, and can be produced in a homogeneous state with an ability to stably exhibit adhesiveness.

That is, adhesive compositions containing a large amount of reactive modified metal oxide particles can exhibit a high refractive index but low light diffusivity. However, addition of light diffusing particles in order to improve the light diffusivity tends to cause precipitation of the light diffusing particles in the process for producing the adhesive composition, which accordingly makes it difficult to produce an adhesive that can stably exhibit adhesiveness. According to the findings by the present inventors here, the use of an organic material as light diffusing particles can particularly prevent precipitation of light diffusing particles while providing high light diffusivity. Therefore, employing such a material imparts a significant effect such that the adhesive composition can have high light diffusivity and a high refractive index, and can be produced in a homogeneous state with an ability to stably exhibit adhesiveness.

The content ratio of the organic light diffusing particles in the adhesive composition of the present invention is preferably 0.5% by weight or more and more preferably 1% by weight or more, and is preferably 15% by weight or less and more preferably 10% by weight or less, with respect to the total amount of the adhesive composition.

### [1. 4. Optional Ingredients]

If necessary, the adhesive composition of the present invention may contain optional ingredients, in addition to the adhesive material, the specific reactive modified metal oxide particles, and the organic light diffusing particles. Examples of such optional ingredients may include silane coupling agents, plasticizers, curing agents, tackifiers, antioxidants, and solvents.

### [1. 4. 1. Silane Coupling Agent]

Examples of silane coupling agents may include vinyltrimetoxysilane, vinyltriethoxysilane, 2-(3,4-epoxycyclohexyl)ethyltrimethoxysilane, 3-glycidoxypropylmethyldimetoxysilane, 3-glycidoxypropyltrimetoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, 3-ureidopropyltriethoxysilane, 3-mercaptopropylmethyldimethoxysilane, 3-mercaptopropyltrimethoxysilane, bis(triethoxysilylpropyl)tetrasulfide, and 3-isocyanatepropyltriethoxysilane. As the silane coupling agent, one type thereof may be solely used, and two or more types thereof may also be used as a mixture.

Example of commercially available silane coupling agents may include trade name "KBM-803" (manufactured by Shin-Etsu Chemical Co., Ltd.).

When the adhesive composition of the present invention contains a silane coupling agent, the content ratio of the silane coupling agent is preferably 0.05 parts by weight or more and more preferably 0.2 parts by weight or more, and is preferably 5 parts by weight or less and more preferably 3 parts by weight or less, with respect to 100 parts by weight of the adhesive material.

### [1. 4. 2. Plasticizer]

The plasticizer may be used for reducing the viscosity of the adhesive composition to maintain adhesiveness. That is, since the adhesive composition of the present invention usually contains a large amount of particles, particularly reactive modified metal oxide particles. Thus the viscosity of the adhesive composition can increase to reduce adhesiveness. In such a case of reduced adhesiveness, the adhesiveness can be maintained by addition of a plasticizer. As a result, both high refractive index and high adhesiveness can be simultaneously achieved.

Examples of plasticizers may include polybutene, vinyl ethers, polyethers (including polyalkylene oxide and functionalized polyalkylene oxide), esters, polyols (for example, glycerol), petroleum resins, hydrogenated petroleum resins, and styrenic compounds (for example, α-methylstyrene).

Of these, esters, particularly aromatic ring-containing esters, such as benzoates and phthalates, may be suitably used because of their favorable miscibility with adhesive materials and relatively high refractive index.

Examples of benzoates that can be used as a plasticizer may include diethylene glycol dibenzoate, dipropylene glycol dibenzoate, benzyl benzoate, and 1,4-cyclohexanedimethanol dibenzoate. Particularly preferable examples of benzoate plasticizers may include dipropylene glycol dibenzoate and benzyl benzoate.

Examples of phthalates that can be used as a plasticizer may include dimethyl phthalate, diethyl phthalate, dibutyl phthalate, butyl benzyl phthalate, dicyclohexyl phthalate, and ethyl phthalyl ethyl glycolate.

Examples of commercially available plasticizers may include trade name "BENZOFLEX 9-88 SG" (manufactured by Eastman).

When the adhesive composition of the present invention contains a plasticizer, the content ratio of the plasticizer is preferably 1 part by weight or more and more preferably 5 parts by weight or more, and is preferably 35 parts by weight or less and more preferably 30 parts by weight or less, with respect to 100 parts by weight of the adhesive material.

### [1. 4. 3. Curing Agent]

Examples of curing agents may include isocyanate compounds, more specifically addition polymers of isocyanates including isophorone diisocyanate, (for example, trade name "NY-260A", manufactured by Mitsubishi Chemical Corporation).

When the adhesive composition of the present invention contains a curing agent, the content ratio of the curing agent is preferably 0.01 parts by weight or more and more preferably 0.05 parts by weight or more, and is preferably 5 parts by weight or less and more preferably 1 part by weight or less, with respect to 100 parts by weight of the adhesive material.

### [1. 4. 4. Tackifier]

Examples of tackifiers may include petroleum-based resins (for example, liquid paraffin, alicyclic saturated hydrocarbon resins), terpene resins, rosin resins, cumarone indene resins, and styrenic resins (for example, styrene resin, α-methylstyrene).

When the adhesive composition of the present invention contains a tackifier, the content ratio of the tackifier is preferably 50 parts by weight or less, and more preferably 30 parts by weight or less with respect to 100 parts by weight of the adhesive material on nonvolatile content (solid content) basis. The lower limit of tackifier content is not limited to any particular value, but usually 1 part by weight or more of the tackifier is preferably used with respect to 100 parts by weight of the adhesive material.

### [1. 4. 5. Antioxidant]

Examples of antioxidants may include hindered phenol-based and phosphite-based antioxidants. When the adhesive composition of the present invention contains an antioxidant, the content of the antioxidant is preferably 10 parts by weight or less, and more preferably 0.1 to 1 part by weight with respect to 100 parts by weight of the adhesive material.

### [1. 4. 6 Solvent]

Examples of solvents may include the same examples of organic solvents for use in the production of the reactive modified metal oxide particles.

When the adhesive composition of the present invention contains a solvent, the content ratio of the solvent is preferably 50 parts by weight or more and more preferably 100 parts by weight or more, and is preferably 300 parts by weight or less and more preferably 250 parts by weight or less, with respect to 100 parts by weight of the total solids.

Production by a method using a solvent, or purchase of commercially available products may result in a solution or suspension in which the adhesive material, the reactive modified metal oxide particles, the organic light diffusing particles, and the optional ingredients as described above are dissolved or dispersed. In this case, the solvents contained in the ingredients may also be mixed as they are as a part of solvent or the entire solvent that is an ingredient of the adhesive composition of the present invention.

### [1. 5. Production Method]

The method for producing the adhesive composition of the present invention is not limited to any particular method, and the adhesive composition may be obtained by appropriately mixing the aforementioned ingredients.

It is preferable to obtain the adhesive composition with the following mixing order:
(i) first mixing a suspension containing reactive modified metal oxide particles and a suspension containing organic light diffusing particles to prepare a suspension containing these particles;
(ii) further adding an adhesive material and, if necessary, a plasticizer to the suspension, followed by kneading to give a mixture; and
(iii) further adding reactive optional ingredients (silane coupling agent, curing agent, etc.) to the mixture.

Mixing the materials in this order enables facilitated production of the adhesive composition in which the reactive modified metal oxide particles are mixed well with the organic light diffusing particles. In any step of the mixing in this order, a solvent may be further added, if necessary, for operations such as adjustment of the viscosity.

It is preferable that the mixing operation in the step (i) is performed using a ball mill to disperse the reactive modified metal oxide particles and the organic light diffusing particles. Specifically, the mixing operation may be performed by loading an appropriate container with a suspension containing the reactive modified metal oxide particles, a suspension containing the organic light diffusing particles, and balls for dispersion, and then placing the container on a ball mill rack, followed by rotation.

### [2. Adhesive Layer]

The adhesive layer of the present invention is formed from the optical-member adhesive composition of the present invention. For example, the adhesive layer of the present invention may be formed by applying the adhesive composition onto the surface of a given optical member and carrying out an optional operation for curing (for example, drying). Furthermore, aging may optionally be performed for stabilizing the ingredients in the adhesive layer to achieve stabilized uniform adhesiveness. Aging is preferably performed for one day or more under heating condition at 35°C or more. The upper limit of the temperature for aging may be, e.g., 80°C or less. The upper limit of the number of days for aging may be, e.g., 15 days or less. Before or after such a curing operation, the layer of the adhesive composition is brought into contact with another optical member to provide the adhesive layer of the present invention as a layer between these two optical members, thereby bonding such two optical members.

The adhesive layer of the present invention may contain the ingredients that were present in the optical-member adhesive composition of the present invention, although some of the ingredients may be changed by reactions and some of the ingredients may volatilize and escape. For example, the drying step may cause reactions of reactive ingredients, such as the silane coupling agent and the curing agent, into other substances, or may cause the solvent to volatilize and escape.

The shape of the adhesive layer of the present invention is not limited to any particular shape, and may be any shape suitable for achieving the bonding of the optical members. In a typical example, the adhesive layer of the present invention may be a flat layer that is present between the surfaces of two flat optical members. Alternatively, when the surface of the optical member has a concavo-convex structure, the adhesive layer of the present invention may be a layer having a concavo-convex structure corresponding to the concavo-convex structure of the surface of the optical member.

The thickness of the adhesive layer of the present invention is not limited to any particular thickness, but is preferably 3 µm or more and more preferably 5 µm or more, and is preferably 50 µm or less and more preferably 30 µm or less.

The adhesive layer of the present invention may have a high refractive index. For example, the adhesive layer may have a refractive index of preferably 1.55 or more, and more preferably 1.60 or more. The upper limit of the refractive index may be, e.g., 1.75 or less. The refractive index may be measured with an ellipsomter (M-2000, manufactured by J. A. Woollam Japan Corporation).

Since the adhesive layer of the present invention has high light diffusivity, it may be difficult to measure the refractive index thereof. In such a case, the refractive index may be measured by preparing a sample for refractive index measurement in the same manner as for the adhesive layer to be measured except that no organic light diffusing particles are added, and measuring the refractive index of the sample. In general, addition of only a small amount of light diffusing particles significantly changes the light diffusivity but the addition of such a small amount gives almost no change in the refractive index. Thus, by using the sample to which no light diffusing particles are added, the value of the refractive index that is substantially the same as that of the adhesive layer of the present invention can be measured.

The adhesive layer of the present invention may have high light diffusivity. For example, haze may be preferably 30% or more, more preferably 50% or more. The adhesive layer of the present invention having such high refractive index and light diffusivity can impart to the optical member desired performances such as high light extraction efficiency. The upper limit of the haze may be, e.g., 98% or less.

### [3. Application]

The adhesive composition of the present invention is an adhesive composition for optical members, and the adhesive layer of the present invention is an adhesive layer for optical members. Preferable examples of such optical members may include light extraction films. A light extraction film is a film provided on the light exiting surface of an organic EL element as a component of a surface light source device including the organic EL element. By bonding the light extraction film with another member of the surface light source device via the adhesive layer of the present invention, light extraction efficiency can be advantageously increased.

### [4. Surface Light Source Device]

The surface light source device of the present invention includes: an organic EL element containing a luminescent layer; a light-transmissive substrate closer to a light exiting surface than the organic EL element; and a light diffusion layer provided on the surface, which is opposite to the surface where the organic EL element is provided, of the light-transmissive substrate.

### [4. 1. First Embodiment]

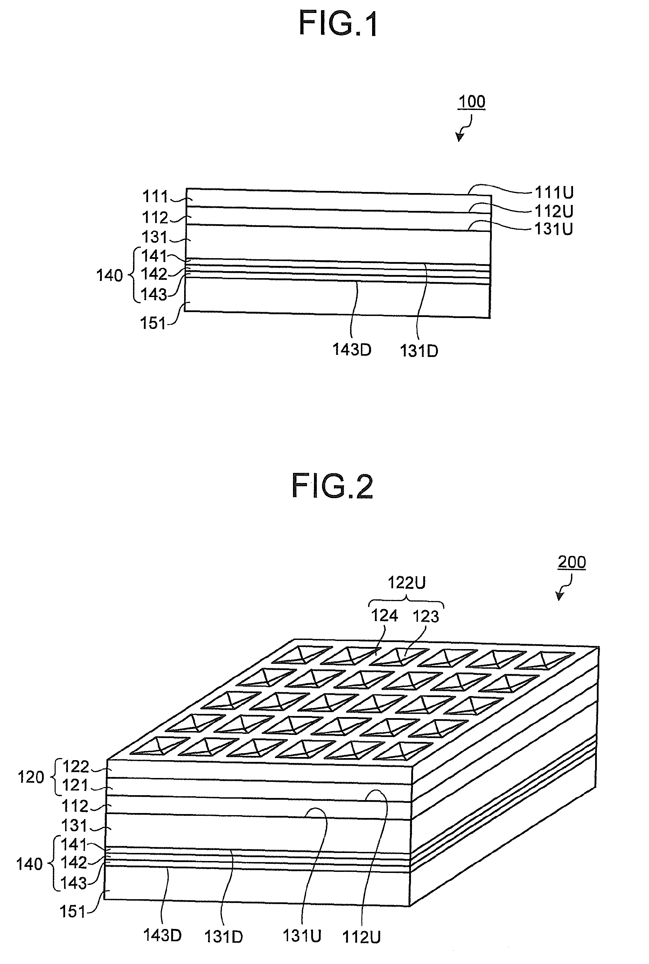

Fig. 1 is a cross-sectional view schematically showing a first embodiment as an example of a surface light source device of the present invention. In Fig. 1, the surface light source device 100 is shown in a state being placed with a light exiting surface 111U thereof placed horizontally facing upward. The light exiting surface 111U is a light exiting surface for the entire surface light source device. That is, light generated in the device exits out of the device through the surface 111U. The light exiting surface for the entire surface light source device may be simply referred to hereinbelow as a "device light exiting surface."

The surface light source device 100 includes: a light-transmissive substrate 131; an organic EL element 140 provided on a lower surface 131D of the light-transmissive substrate 131; and a sealing substrate 151 provided on a lower surface 143D of the organic EL element 140. The surface light source device 100 further includes: a light diffusion layer 112 provided on a surface opposite to the surface where the organic EL element 140 is provided, i.e., an upper surface 131U, of the light-transmissive substrate 131; and a film 111 provided on an upper surface 112U of the light diffusion layer 112. In this example, the film 111 is positioned closest to the uppermost surface of the device, i.e., the device light exiting surface, and the upper surface 111U of the film 111 forms the device light exiting surface.

The organic EL element 140 includes a first electrode layer 141, a second electrode layer 143, and a luminescent layer 142 disposed between the layers 141 and 143. In the first embodiment, light emission from the light exiting surface can be achieved by using a transparent electrode layer as the first electrode layer 141 and a reflective electrode layer as the second electrode layer 143.

### [4. 1. 1. Light Diffusion Layer]

In the present invention, the light diffusion layer includes a light-transmissive resin and light diffusing particles.

### [4. 1. 1. 1. Light-transmissive Resin]

The light-transmissive resin may be any resin that can form a light-transmissive layer. It is preferable that the light-transmissive resin is a resin having not only light-transmissive property but also adhesiveness (this material may be referred to hereinbelow as an "adhesive material") is used to form a diffusion adhesive layer as the light diffusion layer from the viewpoint of facilitating production of the surface light source device. By employing the diffusion adhesive layer as the light diffusion layer, necessity to form another adhesive layer can be eliminated, and as a result reduction in thickness of the device and improvement in light extraction efficiency can be achieved.

The diffusion adhesive layer is a layer that has a function of a light diffusion layer and has ability to bond adjacent layers. As the adhesive material, a resin used as an adhesive for optical materials may be appropriately used. As used herein, the adhesive encompasses not only adhesives in a narrow sense (adhesives having a shear storage modulus at 23°C of less than 1 MPa and exhibiting adhesiveness at normal temperature) but also so-called hot-melt type adhesives having a shear storage modulus at 23°C of from 1 to 500 MPa and exhibiting no adhesiveness at normal temperature. Examples of suitable materials for forming the diffusion adhesive layer may include the aforementioned adhesive materials.

### [4. 1. 1. 2. Light Diffusing Particles]

Light diffusing particles are particles that are capable of scattering light incident on the light diffusion layer. As the light diffusing particles, particles that are capable of imparting properties such as desired scattering anisotropy coefficient g to the light diffusion layer may be appropriately selected.

The particle diameter of the light diffusing particles may be selected in the range that can impart properties such as desired scattering anisotropy coefficient g to the light diffusion layer. Specifically, e.g., the volume average particle diameter is preferably 0.2 µm or larger, more preferably 0.4 µm or larger, and still more preferably 0.5 µm or larger, and is preferably 5 µm or smaller and more preferably 3 µm or smaller.

The refractive index of the light diffusing particles may be selected in the range that can impart properties such as desired scattering anisotropy coefficient g to the light diffusion layer. Specific refractive index is preferably, e.g., from 1.4 to 1.55. Preferable examples of the light diffusing particles may include the aforementioned organic light diffusing particles.

### [4. 1. 1. 3. Other Ingredients in Light Diffusion Layer]

The light diffusion layer may contain optional materials in addition to the light-transmissive resin and the light diffusing particles. Examples of such optional materials may include materials such as reactive modified metal oxide particles, a plasticizer, a silane coupling agent, a curing agent, a tackifier, and an antioxidant. Specific examples thereof are as described above.

### [4. 1. 1. 4. Properties of Light Diffusion Layer]

The light diffusion layer has a scattering anisotropy coefficient g of 0.83 or more and 0.97 or less. The upper limit of the value g is preferably 0.9675 or less, and more preferably 0.965 or less. The lower limit of the value g is preferably 0.8325 or more, and more preferably 0.835 or more.

By setting the value g to a value that is as small as not more than the upper limit, change in color tone depending on the observation angle can be reduced. However, a too small value g results in reduction in light extraction efficiency. Thus by setting the value g in the aforementioned range, light extraction efficiency can be increased and color tone change can be reduced as well. The value of scattering anisotropy coefficient g may be calculated using the scattering phase function derived from the Mie scattering theory. In the light diffusion layer having such a scattering anisotropy coefficient g, the scattering anisotropy coefficient g may be controlled in a desired range by appropriately selecting the refractive index of the light diffusing particles, the refractive index of other parts than the light diffusing particles of the light diffusion layer, the particle diameter of the light diffusing particles, and the content of the light diffusing particles.

The refractive index difference between the light diffusion layer and the light-transmissive substrate is 0.1 or less, and preferably 0.08 or less. The lower limit of the refractive index difference is ideally zero. By setting the refractive index difference to a value in the aforementioned range, light extraction efficiency can be increased. In particular, use of a layer having a value g in the aforementioned specific range as the light diffusion layer may achieve both high light extraction efficiency and small change in color tone depending on the observation angle on the light exiting surface.

The refractive index of the light diffusion layer is not limited to any particular refractive index, but preferably from 1.42 to 1.65, and more preferably from 1.48 to 1.62 from the viewpoint of facilitating attainment of the structure having a refractive index close to that of the light-transmissive substrate. The refractive index of the light diffusion layer may be measured with an ellipsomter (for example, M-2000, manufactured by J. A. Woollam Japan Corporation). Since the light diffusion layer contains the light diffusing particles, it may be difficult to measure the refractive index thereof. Since the amount of the light diffusing particles added to the light diffusion layer is usually very small, there are little difference in refractive index between the light diffusion layer that contains the light diffusing particles and the layer that does not. Therefore, when it is difficult to measure the refractive index of the light diffusion layer, a layer for measurement may be separately prepared in the same procedure as in the method for preparing the light diffusion layer except that no light diffusing particles are added, and the refractive index of the layer may be measured as the refractive index of the light diffusion layer.

The thickness of the light diffusion layer is preferably in the range of 3 to 25 µm for facilitating formation of the diffusion layer and the performance thereof. When the thickness is thinner the aforementioned range, the content of the diffusing particles needs to be significantly increased, which may make it difficult to form the diffusion layer. When it is too thick, the extraction efficiency may decrease.

### [4. 1. 1. 5. Method of Forming Light Diffusion Layer]

The method for forming the light diffusion layer is not limited to any particular method. The light diffusion layer may be formed by preparing a solution for light diffusion layer formation, applying the solution onto a suitable member to form a coating layer, and drying the coating layer, if necessary. The solution for light diffusion layer formation may be prepared by mixing the light-transmissive resin and the light diffusing particles as described above, optional materials such as reactive modified metal oxide particles, if necessary, and a solvent, if necessary. The solvent is not limited to any particular solvent, and any of water and organic solvent may be appropriately selected for use. When commercially available materials containing solids and solvents are used as materials for the light-transmissive resin, the light diffusing particles, the reactive modified metal oxide particles, etc., the solvents contained in the materials as they are may be used as solvents in the solution for light diffusion layer formation.

Preferable examples of solutions for light diffusion layer formation may include the aforementioned optical-member adhesive composition.

### [4. 1. 2. Light-transmissive Substrate]

The light-transmissive substrate is a layer that supports the organic EL element. By having as the light-transmissive substrate a substrate having a capability of finely sealing the organic EL element and facilitating sequential formation of layers constituting the organic EL element on the substrate in the production process, durability of the surface light source device can be improved and production of the surface light source device can be facilitated.

As materials constituting the light-transmissive substrate, light-transmissive materials may be appropriately selected. Examples of such materials may include glass and resin. As the material for the light-transmissive substrate, one type thereof may be solely used, and two or more types thereof may also be used in combination at any ratio.

The refractive index of the material constituting the light-transmissive substrate is not limited to any particular refractive index, but preferably from 1.4 to 2.0. The thickness of the light-transmissive substrate is not limited to any particular thickness, but preferably from 0.02 mm to 5 mm.

In the present invention, the light-transmissive substrate being "light-transmissive" means having a light transmittance suitable for use as a material for the surface light source device. In the present invention, layers designed to allow light to pass therethrough among the layers constituting the surface light source device may have a light transmittance suitable for use as the optical member. For example, the entire device from the substrate to the device light exiting surface (including the light-transmissive substrate and the light diffusion layer) may have a total light transmittance of 50% or more.

### [4. 1. 3. Organic EL element]

The organic EL element includes a luminescent layer. The organic EL element usually includes, e.g., as illustrated as organic EL element 140, two or more electrode layers and a luminescent layer interposed between the electrode layers and emitting light upon application of voltage from the electrode layers.

The organic EL element may be formed by sequentially forming, on the light-transmissive substrate, layers including the electrode layers and the luminescent layer that constitute the organic EL element by a known method, such as sputtering. In general, a sealing member that covers these layers is further provided to form a structure in which the layers such as the luminescent layer are sealed with the light-transmissive substrate and the sealing member.

The luminescent layer is not limited to any particular luminescent layer, and any known one may be appropriately selected. As the luminescent material in the luminescent layer, one type thereof may be solely used, and two or more types thereof may also be used in combination at any ratio. The luminescent layer is not limited to a single layer. The luminescent layer may be solely one type of layer, or a combination of a multiple types of the layers for adaptation to applications as light sources. This enables emission of light of white color or colors similar thereto.

Among the electrode layers constituting the organic EL element, at least one thereof is a transparent electrode layer formed from a light-transmissive material. As the material for the transparent electrode layer, one type thereof may be solely used, and two or more types thereof may also be used in combination at any ratio. Furthermore, the transparent electrode layer may be of a single layer structure including only one layer, or may be of a multilayer structure including two or more layers. In the first embodiment illustrated in Fig. 1, the first electrode layer 141 is a transparent electrode layer, and the second electrode layer 143 is a reflective electrode layer.

The organic EL element 140 may further include other layers in addition to the luminescent layer 142, between the first electrode layer 141 and the second electrode layer 143. Examples thereof may include a hole injection layer, a hole transport layer, an electron transport layer, and an electron injection layer (not shown). The organic EL element 140 may further include optional components, such as wiring for applying electricity to the first electrode layer 141 and the second electrode layer 143, and a peripheral structure for sealing the luminescent layer 142.

The materials constituting the electrode layers and layer(s) provided therebetween are not limited to any particular materials, but specific examples may include the followings.

Examples of the materials for the electrode layer may include indium tin oxide (ITO), aluminum, and silver.

Examples of the materials for the hole injection layer may include starburst-type aromatic diamine compounds.

Examples of the materials for the hole transport layer may include triphenyldiamine derivatives.

Examples of the host materials for a yellow luminescent layer may include triphenyldiamine derivatives, and examples of dopant materials for the yellow luminescent layer may include tetracene derivatives.

Examples of the materials for a green luminescent layer may include pyrazoline derivatives.

Examples of the host materials for a blue luminescent layer may include anthracene derivatives, and examples of the dopant materials for the blue luminescent layer may include perylene derivatives.

Examples of the materials for a red luminescent layer may include europium complexes.

Examples of the materials for the electron transport layer may include aluminum quinoline complexes (Alq).

The aforementioned layers or other luminescent layers may be suitably combined to constitute a so-called layered or tandem luminescent layer that generates light of complementary colors. The combination of complementary colors may be, e.g., yellow-blue, or green-blue-red.

### [4. 1. 4. Other Components]

The surface light source device of the present invention may include optional components in addition to the organic EL element, the light-transmissive substrate, and the light diffusion layer. For example, the surface light source device may include a layer constituting a device light exiting surface, like the film 111 of the surface light source device 100 of the first embodiment, in the position closer to the device light exiting surface than the light diffusion layer. The surface light source device may also have, e.g., a substrate for sealing the surface, which is opposite to the surface where the light-transmissive substrate is provided, of the organic EL element, like sealing substrate 151 in the first embodiment.

### [4. 1. 5. Method of Producing Surface Light Source Device]

The method for producing the surface light source device according to the present invention is not limited to any particular method, and the surface light source device may be produced by forming the layers constituting the device in a suitable order. For example, a multilayer structure including the light-transmissive substrate and the organic EL element and a multilayer structure including a member (for example, the film 111 in Fig. 1) defining the device light exiting surface and a layer of the material of the diffusion adhesive layer are formed. These multilayer structures may be bonded together via the adhesiveness of the diffusion adhesive layer to form a multilayer structure having a layer structure of (organic EL element) / (light-transmissive substrate) / (light diffusion layer) / (film). This multilayer structure is further provided with optional components such as a sealing member, if necessary, to produce the surface light source device.

### [4. 1. 6. Performance of Surface Light Source Device]

The surface light source device of the present invention has effects of high light extraction efficiency and small change in color tone depending on the observation angle.

The light extraction efficiency may be evaluated on the basis of the light extraction efficiency Q obtained from equation Q = (the amount of light extraction from the surface light source device of the present invention) / (the amount of light extraction from a control surface light source device) in comparison of the surface light source device of the present invention having the light diffusion layer to the control surface light source device having the same structure except for absence of the light diffusion layer. The control surface light source device for use may be the one that is different from the surface light source device of the present invention only in whether the light diffusion layer is present or not, or may be the one that is different in other components that have no large impact on the light extraction efficiency. For example, the control surface light source device for obtaining the light extraction efficiency Q of the surface light source device of the first embodiment illustrated in Fig. 1 may be a device having neither light diffusion layer 112 nor film 111.

The change in color tone depending on the observation angle may be evaluated on the basis of, e.g., the value Δxy, which is the maximum value of the square root of (xθ - xθ)2 + (yθ - yθ)2 calculated from the values of xθ and yθ of the chromaticity coordinates (x, y) at given angles θ from polar angles 0° to 60° and the values of x0 and y0 of the chromaticity coordinates (x, y) at a polar angle of 0°.

The value calculated from the equation Q x (1 - Δxy) on the basis of the values of light extraction efficiency Q and Δxy may be used as an index of the effects of the present invention having high light extraction efficiency and small change in color tone depending on the observation angle. In particular, the surface light source device having the value of 1 or more may be evaluated as one having high extraction efficiency and small color tone changes in a well-balanced manner.

### [4. 2. Second Embodiment]

The shape of the device light exiting surface of the surface light source device according to the present invention is not limited to any particular shape, and may be a flat surface shape as described above in the first embodiment or may be a surface shape having a concavo-convex structure as in the second embodiment that will be described in the following.

Fig. 2 is a perspective view schematically showing the second embodiment as another example of the surface light source device of the present invention. In Fig. 2, a surface light source device 200 is shown in a state being placed with the light exiting surface thereof placed horizontally facing upward in the same manner as the surface light source device 100 in Fig. 1.

The surface light source device 200 is different from the surface light source device 100 in that the light exiting surface structure layer 120, in place of the film 111, is provided on the upper surface 112U of the light diffusion layer 112 and the other components are common to the surface light source device 100.

### [4. 2. 1. Light Exiting Surface Structure Layer]

The light exiting surface structure layer 120 of the surface light source device 200 of the second embodiment includes a light exiting surface substrate 121 and a concavo-convex structure layer 122. When the surface light source device of the present invention has a light exiting surface structure layer, such a layer may be composed of one layer or may be composed of multiple layers, like the light exiting surface structure layer 120 in this embodiment. The light exiting surface structure layer is preferably composed of multiple layers from the viewpoint of facilitating production.

### [4. 2. 1. 1. Light Exiting Surface Substrate]

The materials constituting the light exiting surface substrate 121 may be the same as or different from the aforementioned materials for the light-transmissive substrate. Examples of such materials may include glass and a variety of types of resins. Examples of resins may include thermoplastic resins, thermosetting resins, ultraviolet curable resins, and electron-beam curable resins. Of these resins, thermoplastic resins are preferable in terms of facilitating processing. Examples of thermoplastic resins may include polyester-based, polyacrylate-based, and cycloolefin polymer-based resins. The light exiting surface substrate is not limited to a single layer but may be stacked multiple layers.

The thickness of the light exiting surface substrate is preferably from 20 to 300 µm, e.g., when the light exiting surface substrate is made of resins. When the light exiting surface substrate is made of glass, the thickness thereof is preferably from 10 to 1,100 µm.

### [4. 2. 1. 2. Concavo-convex structure Layer]

Concavo-convex structure layer 122 has a concavo-convex structure including multiple concave portions 123 and flat part 124 positioned around concave portions 123 on the upper surface of concavo-convex structure layer 122, i.e., on a device light exiting surface 122U. The concavo-convex structure defines the device light exiting surface 122U of the surface light source device 200. When observed macroscopically ignoring the concave portions 123, the device light exiting surface 122U is a flat plane parallel to the flat part 124 and other layers in the surface light source device. Microscopically, the device light exiting surface 122U is a concavo-convex surface including the slopes defined by the concave portions 123. Since the drawings are schematic diagrams in the present application, only a small number of concave portions are shown on the device light exiting surface 122U. In actual devices, much more number of concave portions than those in the drawing may be provided on one light exiting surface structure layer surface.

Examples of the materials for the concavo-convex structure layer may include a variety of types of resins. Examples of such resins may include thermoplastic resins, thermosetting resins, and energy-ray curable resins such as ultraviolet curable resins and electron-beam curable resins. Of these resins, thermoplastic resins and ultraviolet curable resins are preferable because thermoplastic resins are easily deformed by heat and ultraviolet curable resins are efficient by virtue of their high curability, which enable efficient formation of the light diffusion layer having a concavo-convex structure. Examples of thermoplastic resins may include polyester-based, polyacrylate-based, and cycloolefin polymer-based resins. Examples of ultraviolet curable resins may include epoxy-based, acrylic-based, urethane-based, ene/thiol-based, and isocyanate-based resins. Of these resins, those having multiple polymerizable functional groups may be preferably used.

Suitable materials for the concavo-convex structure layer may include materials having high hardness when cured, from the viewpoint of readily forming the concavo-convex structure and readily obtaining the abrasion resistance of the concavo-convex structure. Specifically, materials having a pencil hardness of HB or more are preferable, materials having a pencil hardness of H or more are more preferable, and materials having a pencil hardness of 2H or more are still more preferable, wherein the pencil hardness of a layer of the material formed on the substrate having a thickness of 7 µm with no concavo-convex structure. On the other hand, suitable materials for the light exiting surface substrate are materials having a certain degree of flexibility in order to facilitate handling during the formation of the concavo-convex structure layer and/or after the formation of the light exiting surface structure layer. Combination of such materials can give the light exiting surface structure layer that can be easily handled and has excellent durability. Combination of such materials may be obtained by appropriately selecting the resins from the aforementioned examples as the resins constituting the respective materials. Specifically, ultraviolet curable resins such as acrylate resins may be used as the resin constituting the material for the concavo-convex structure layer, whereas films made of alicyclic olefin polymers and polyester films may be used as the resin constituting the material for the light exiting surface substrate, whereby combination of suitable materials can be obtained.

The concavo-convex structure layer may have light diffusivity originated from the material thereof itself in addition to the light diffusivity originated from the concavo-convex structure. Such a concavo-convex structure layer may be formed from a resin composition having light diffusivity as the material. Specific examples of the resin compositions having light diffusivity may include compositions containing a variety of types of resins and diffusers.

Examples of the diffusers that may be contained in the concavo-convex structure layer may include a variety of types of particles. The particles may be transparent or may be non-transparent. Examples of the materials of the particles for use may include metals, metal compounds, and resins. Examples of metal compounds may include metal oxides and metal nitrides. Specific examples of metals and metal compounds may include highly reflective metals, such as silver and aluminum, and metal compounds, such as silicon oxide, aluminum oxide, zirconium oxide, silicon nitride, tin-doped indium oxide, and titanium oxide. On the other hand, examples of resins contained in the resin composition having light diffusivity may include those as described above, and particularly preferable examples may include methacrylic resins, polyurethane resins, and silicone resins.

The shape of the particles may be shapes such as a spherical shape, a cylindrical shape, a cubic shape, a rectangular cuboid shape, a pyramid shape, a conical shape, and a star shape.

The particle diameter of the particles is preferably 0.1 µm or larger and 10 µm or smaller, and more preferably 5 µm or smaller. As used herein, the particle diameter is a 50% particle diameter in the cumulative distribution in which the cumulative volume of particles is plotted against the particle diameter on the horizontal axis. The larger the particle diameter is, the larger the content ratio of the particles required for obtaining desired effects. The smaller the particle diameter is, the smaller the content ratio can be. Therefore, as the particle diameter is smaller, desired effects such as reduced change in color tone depending on the observation angle and improved light extraction efficiency can be obtained with a smaller amount of particles. If the particle has a shape other than a spherical shape, the diameter of a sphere having the same volume as the particle is taken as the particle diameter.

In the case where the particles are transparent particles and the particles are contained in a resin, the difference between the refractive index of the particles and that of the resin is preferably from 0.05 to 0.5, more preferably from 0.07 to 0.5. Either the particles or the transparent resin may have a higher refractive index. If the refractive index difference between the particles and the resin is too small, diffusion effect cannot be obtained and thus color tone unevenness cannot be suppressed. In contrast, if the difference therebetween is too large, diffusion increases whereby, although color tone unevenness can be suppressed, light extraction effect is reduced.

In the case where the concavo-convex structure layer contains the resin and the diffuser, the ratio of the diffuser mixed in the resin composition is preferably 3 to 50%.

The lower limit of the thickness of the concavo-convex structure layer is preferably 1 µm or more, more preferably 5 µm or more, and may be 10 µm or more. On the other hand, the upper limit thereof is preferably 50 µm or less, more preferably 25 µm or less, and may be 15 µm or less. In particular, when the thickness is not more than the upper limit, deformation, such as curling, of the concavo-convex structure layer due to cure shrinkage can be prevented to thereby provide a concavo-convex structure layer having a favorable shape.

Preferable examples of specific structures of the device light exiting surface defined by the concavo-convex structure layer may include structures including concave portions 123, which are quadrangular pyramid recesses, and a flat part 124 positioned around concave portions 123, like the upper surface 122U of the concavo-convex structure layer 122 of the second embodiment illustrated in Fig. 2.

The light extraction efficiency of the surface light source device can be improved by appropriately controlling the area ratio of the flat part with respect to the total area of the flat part and the concave portions as the concavo-convex structure is viewed from a direction perpendicular to the light exiting surface structure layer (this ratio is referred to hereinbelow as the "flat part ratio"). Specifically, the flat part ratio of 10% to 75% can provide good light extraction efficiency and also can increase the mechanical strength of the device light exiting surface.

In the case where the concavo-convex structure layer has a concavo-convex structure on the surface, the concave portion may have, e.g., a conical shape, a shape being part of spherical surface, a groove shape, and a shape of combinations thereof, in addition to the aforementioned pyramid shape. The pyramid shape may be, but is not limited to, a quadrangular pyramid having a square bottom as exemplified by the concave portion 123, and also may be a pyramid shape such as a triangular pyramid, a pentagonal pyramid, a hexagonal pyramid, and a quadrangular pyramid having a bottom that is not square. Furthermore, a cone and pyramid as used herein may encompass not only ordinary cones and pyramids having a pointed apex but also those having a rounded tip and those having a flat truncated surface (for example, frustum shapes).

The depth of the concave portion in the concavo-convex structure is not limited to any particular depth, but may be in the range of 1 to 50 µm as the maximum value of center line average roughness (Ra(max)) obtained by measuring the surface having the concavo-convex structure formed thereon along a variety of directions (a variety of in-plane directions parallel to the light exiting surface). When the concavo-convex structure is formed on the concavo-convex structure layer, preferable depth of the concave portion may be set relative to the thickness of the concavo-convex structure layer. For example, when a hard material advantageous for maintaining durability of the concavo-convex structure layer is used as a material for the concavo-convex structure layer, the concavo-convex structure layer with thin thickness can make the light exiting surface structure layer more flexible, to thereby facilitate handling of the light exiting surface structure layer in the process of producing the surface light source device.

The angle between the slopes of the concave portions and the light exiting surface is preferably from 40° to 70°, and more preferably from 45° to 60°. On the surface of the concavo-convex structure layer, the plurality of concave portions may be arranged in any manner. For example, the plurality of concave portions may be arranged along two or more directions on the surface. More specifically, the plurality of concave portions may be arranged along two orthogonal directions on the light exiting surface, like the concave portions 123 illustrated in Fig. 1. In the case where the concave portions are arranged in two or more directions, the adjacent concave portions may be provided with gaps in one or more of the two or more directions, so that the gap can form the flat part. Employing such a structure can achieve both good light extraction efficiency and mechanical strength of the sheet surface.

### [4. 2. 1. 3. Method of Forming Light Exiting Surface Structure Layer]

The method for forming the light exiting surface structure layer is not limited to any particular method. The layer may be formed by a known method. For example, the light exiting surface structure layer may be formed by providing a concavo-convex structure layer on one surface of the light exiting surface substrate using the aforementioned material for the concavo-convex structure layer by a photopolymer method (2P method).

### [4. 3. Application of Surface Light Source Device]

The surface light source device of the present invention may be used in applications such as lighting devices and backlight devices.

The lighting device may have the surface light source device of the present invention as a light source and may further include optional components, such as a member for holding the light source and a circuit for supplying electric power. The backlight device may have the surface light source device of the present invention as a light source and may further include optional components, such as an enclosure and a circuit for supplying electric power, as well as a diffuser plate, a diffuser sheet, and a prism sheet for further uniforming light emission. The backlight device may be used as a backlight for display apparatuses that display images by the control of pixels, such as liquid crystal display apparatuses, and for display apparatuses that display fixed images, such as signboards.

### [4. 4. Others]

The present invention is not limited to the aforementioned specific examples, and any modifications may be made within the scope of the claims of the present application and equivalents thereto.

For example, in the surface light source device of the present invention, the replacement of the reflective electrode layer in the aforementioned specific example with a transparent electrode layer and a reflective layer may still provide a device having the same effects as one having the reflective electrode layer.

In addition, e.g., the replacement of the reflective electrode layer in the aforementioned specific example with a transparent electrode layer and furthermore the use of the same material as for the light-transmissive substrate as a sealing substrate may provide a see-through type surface light source device which enables double-sided luminescence and through which the other side of the device can be seen. In this case, a light diffusion layer may be provided under the sealing substrate to achieve improved light extraction efficiency and reduced color tone changes of the light exiting surface on both sides.

### Examples

The present invention will be described hereinbelow in more detail with reference to Examples and Comparative Examples. However, the present invention is not limited to the following Examples. Unless otherwise specified, "%" and "part" in the following expressing the quantitative ratio of ingredients are by weight.

### (Example 1)

### (1-1: Preparation of Adhesive Composition)

A plastic container was charged with 188 parts by weight of a reactive modified zirconia oxide slurry (trade name "ZR-010" manufactured by Solar Co., Ltd., solvent: methyl ethyl ketone, particle content ratio 30%, organic substance having a reactive functional group modifying the surface: isocyanate having a polymerizable functional group, volume average particle diameter 15 nm), 3.3 parts by weight of silicone particles (trade name "XC-99" manufactured by Momentive Performance Materials Inc.), and 564 parts by weight of zirconia balls for dispersion (trade name "YTZ-0.5" manufactured by Nikkato Corporation). The plastic container was placed on a ball mill rack to perform ball mill dispersion at a rate of 2 revolutions per second for 30 minutes. After ball mill dispersion, the zirconia balls were removed with a sieve to give a mixture 1.

After the resulting mixture 1 was placed in a glass vial and allowed to stand for 2 hours, whether precipitates of diffusing particles were present or not was visually determined. As a result, no precipitate was observed.

To the mixture 1, 100 parts by weight of an acrylic-based adhesive (trade name "X-311033S" manufactured by Saiden Chemical Industry Co., Ltd., solid content 35%) and 5 parts by weight of a plasticizer (trade name "BENZOFLEX 9-88 SG" manufactured by Eastman, diethylene glycol dibenzoate) were added and stirred for 15 minutes. Subsequently, 1 part by weight of a silane coupling agent (trade name "KBM-803" manufactured by Shin-Etsu Chemical Co., Ltd., 3-mercaptopropyltrimethoxysilane) and 0.6 parts by weight of a curing agent (trade name "NY-260A" manufactured by Mitsubishi Chemical Corporation) were added and stirred for 15 minutes to give an adhesive composition.

### (1-2: Formation of Adhesive Layer)

The adhesive composition obtained in the step (1-1) was applied at a thickness which gives a thickness after drying of 20 µm onto one side of a polyethylene terephthalate film of 100 µm thick (trade name "U34" manufactured by Toray Industries, Inc.), and dried at 80°C for 5 minutes to form an adhesive layer, whereby an adhesive sheet having the adhesive layer was prepared.

### (1-3: Measurement of Peel Strength)

The adhesive sheet obtained in the step (1-2) was cut out to have a 10 mm wide and 100 mm long piece. This piece was bonded to a glass plate with a roller. 24 hours after bonding, the peel strength in the length direction was measured with a peel testing machine under the conditions of a rate of 20 mm/min at 90°. The results are shown in Table 2.

### (1-4: Measurement of Refractive Index)

A silicone particle-free adhesive composition was obtained in the same procedure as in (1-1) except that no silicone particles were added.

The silicone particle-free adhesive composition was applied at a thickness which gives a thickness after drying of 10 µm onto one side of a glass plate and dried at 80°C for 5 minutes to form an adhesive layer. The refractive index of the adhesive layer was measured with an ellipsomter (M-2000 manufactured by J. A. Woollam Japan Corporation). The results are shown in Table 2.

### (Examples 2 to 10)

Mixtures 1, adhesive compositions, adhesive sheets having an adhesive layer, and particle-free adhesive compositions were obtained and evaluated in the same procedure as in Example 1 except that the types and amounts of the materials used were changed as shown in Table 1.
The results are shown in Table 2. In the visual evaluation of the mixtures 1 in all of Examples 2 to 10, no precipitate was observed.

### (Comparative Examples 1 to 3)

Mixtures 1, adhesive compositions, and adhesive sheets having an adhesive layer were produced and evaluated in the same procedure as in Example 1 except that the types and amounts of the materials used were changed as shown in Table 1. In the visual evaluation of the mixtures 1 in all of Comparative Examples 1 to 3, precipitate was observed. An attempt was made to produce an adhesive composition and an adhesive sheet using the mixture 1. However, uniform mixing was not achieved, and it was thus unable to obtain a composition whose peel strength was effectively measurable.

**Table 1**

| | ZrO2 slurry | TiO2 slurry | Silicone particles | Acrylic particles | Polystyrene particles | Silica particles | Talc particles | Adhe sive | Plasticizer | Coupling agent | Curing agent |
|---|---|---|---|---|---|---|---|---|---|---|---|
| Ex. 1 | 188 | - | 3.3 | - | - | - | - | 100 | 5.0 | 1.0 | 0.6 |
| Ex. 2 | 250 | - | 3.3 | - | - | - | - | 100 | 5.0 | 1.0 | 0.6 |
| Ex. 3 | 150 | - | 3.3 | - | - | - | - | 100 | 5.0 | 1.0 | 0.6 |
| Ex. 4 | 100 | - | 3.3 | - | - | - | - | 100 | 5.0 | 1.0 | 0.6 |
| Ex. 5 | - | 150 | 3.3 | - | - | - | - | 100 | 5.0 | 1.0 | 0.6 |
| Ex. 6 | - | 100 | 3.3 | - | - | - | - | 100 | 5.0 | 1.0 | 0.6 |
| Ex. 7 | 188 | - | - | 3.3 | - | - | - | 100 | 5.0 | 1.0 | 0.6 |
| Ex. 8 | 188 | - | - | - | 3.3 | - | - | 100 | 5.0 | 1.0 | 0.6 |
| Ex. 9 | 188 | - | 3.3 | - | - | - | - | 100 | 2.5 | 1.0 | 0.6 |
| Ex. 10 | 188 | - | 3.3 | - | - | - | - | 100 | 0.0 | 1.0 | 0.6 |
| Comp. Ex. 1 | 188 | - | - | - | - | 3.3 | - | 100 | 5.0 | 1.0 | 0.6 |
| Comp. Ex. 2 | 188 | - | - | - | - | - | 3.3 | 100 | 5.0 | 1.0 | 0.6 |
| Comp. Ex. 3 | - | 188 | - | - | - | 3.3 | - | 100 | 5.0 | 1.0 | 0.6 |

**Table 2**

| | Precipitation | Refractive index (550nm) | Peel strength 20µm thickness N/10mm |
|---|---|---|---|
| Ex. 1 | No | 1.65 | 4.6 |
| Ex. 2 | No | 1.70 | 4.5 |
| Ex. 3 | No | 1.61 | 4.8 |
| Ex. 4 | No | 1.58 | 5.0 |
| Ex. 5 | No | 1.70 | 2.9 |
| Ex. 6 | No | 1.60 | 3.7 |
| Ex. 7 | No | 1.63 | 4.2 |
| Ex. 8 | No | 1.64 | 4.3 |
| Ex. 9 | No | 1.65 | 2.5 |
| Ex. 10 | No | 1.65 | 1.2 |
| Comp. Ex. 1 | Yes | - | - |
| Comp. Ex. 2 | Yes | - | - |
| Comp. Ex. 3 | Yes | - | - |

All of the values regarding materials are based on parts by weight. The abbreviations in the tables mean the followings, respectively.
ZrO₂ slurry: trade name "ZR-010" manufactured by Solar Co., Ltd., solvent: methyl ethyl ketone, particle content ratio 30%, organic substance having a reactive functional group modifying the surface: isocyanate having a polymerizable functional group, volume average particle diameter 15 nm
TiO2 slurry: trade name "NOD-742GTF" manufactured by Nagase chemteX Corporation, solvent: polyethylene glycol monomethyl ether, particle content ratio 30%, volume average particle diameter 48 nm
Silicone particles: trade name "XC-99" manufactured by Momentive Performance Materials Inc., volume average particle diameter 0.7 µm
Acrylic particles: trade name "MP series" manufactured by Soken Chemical & Engineering Co., Ltd., volume average particle diameter 0.8 µm
Polystyrene particles: trade name "SX series" manufactured by Soken Chemical & Engineering Co., Ltd., volume average particle diameter 3.5 µm
Silica particles: trade name "SR series" manufactured by M Tech Chemical Co., Ltd, volume average particle diameter 0.4 µm
Talc particles: trade name "D-800" manufactured by Nippon Talc Co., Ltd., volume average particle diameter 0.8 µm
Adhesive: trade name "X-311033S" manufactured by Saiden Chemical Industry Co., Ltd., solvent: ethyl acetate, solid content ratio 35%
Plasticizer: trade name "BENZOFLEX 9-88 SG" manufactured by Eastman
Coupling agent: trade name "KBM-803" manufactured by Shin-Etsu Chemical Co., Ltd.
Curing agent: trade name "NY-260A" manufactured by Mitsubishi Chemical Corporation
Precipitation: whether the precipitation of diffusing particles in the mixture 1 is present or not

It is apparent from the results shown in Table 2 that, in Examples 1 to 10 which satisfied the requirements of the present invention, favorable adhesive compositions and adhesive layers were obtained without any precipitation of the particles during production. On the other hand, in Comparative Examples 1 to 3 using inorganic particles as light diffusing particles, favorable adhesive compositions and adhesive layers were not obtained due to precipitation of the particles.

### <Example 11>

### (11-1. Production of Organic EL Element 1)

On one surface of a glass substrate having a thickness of 0.7 mm and a refractive index of 1.52, a transparent electrode layer of 100 nm, a hole transport layer of 10 nm, a yellow luminescent layer of 20 nm, a blue luminescent layer of 15 nm, an electron transport layer of 15 nm, an electron injection layer of 1 nm, and a reflective electrode layer of 100 nm were formed in this order. The layers from the hole transport layer to the electron transport layer were all formed with organic materials. The yellow luminescent layer and the blue luminescent layer have different emission spectrums.

The materials for forming the layers from the transparent electrode layer to the reflective electrode layer were as follows:
- Transparent electrode layer: tin-doped indium oxide (ITO)
- Hole transport layer: 4,4'-bis[(N-(naphthyl)-N-phenylamino)]biphenyl (α-NPD)
- Yellow luminescent layer: 1.5 wt% rubrene-doped α-NPD
- Blue luminescent layer: 10 wt% iridium complex-doped 4,4'-dicarbazolyl-1,1'-biphenyl (CBP)
- Electron transport layer: phenanthroline derivative (BCP)
- Electron injection layer: lithium fluoride (LiF)
- Reflective electrode layer: Al

The transparent electrode layer was formed by a reactive sputtering method using an ITO target, and the surface resistance was made 10 Ω/□ or lower. The layers from the hole injection layer to the reflective electrode layer were formed by installing the glass substrate having the transparent electrode layer already formed thereon in a vacuum vapor deposition apparatus, and sequentially vapor-depositing the materials for the layers from the aforementioned hole transport layer to the reflective electrode layer by resistance heating. The vapor deposition was performed with system internal pressure of 5 × 10⁻³ Pa and evaporation rate of 0.1 to 0.2 nm/s.

Further, wiring for applying electricity to the electrode layers was attached and the layers from the hole transport layer to the reflective electrode layer were sealed with a sealing substrate. This provided an organic EL element 1 having a layer structure of (glass substrate) / (transparent electrode layer) / (hole transport layer) / (yellow luminescent layer) / (blue luminescent layer) / (electron transport layer) / (electron injection layer) / (reflective electrode layer) / (sealing substrate).

### (11-2: Preparation of Adhesive Composition)

A plastic container was charged with 75 parts by weight of a reactive modified zirconia oxide slurry (trade name "ZR-010" manufactured by Solar Co., Ltd., solvent: methyl ethyl ketone, particle content ratio 30%, organic substance having a reactive functional group modifying the surface: isocyanate having a polymerizable functional group, volume average particle diameter 15 nm), 3.3 parts by weight of light scattering particles (silicone particles having a volume average particle diameter of 0.4 µm, trade name "XC-99" manufactured by Momentive Performance Materials Inc.), and 564 parts by weight of zirconia balls for dispersion (trade name "YTZ-0.5" manufactured by Nikkato Corporation). The plastic container was placed on a ball mill rack to perform ball mill dispersion at a rate of 2 revolutions per second for 30 minutes. After ball mill dispersion, the zirconia balls were removed with a sieve to give a mixture 1.

To the mixture 1, 100 parts by weight of an acrylic-based adhesive (trade name "X-311033S" manufactured by Saiden Chemical Industry Co., Ltd., solid content 35%) and 5 parts by weight of a plasticizer (name "BENZOFLEX 9-88 SG" manufactured by Eastman, diethylene glycol dibenzoate) were added and stirred for 15 minutes. Subsequently, 1 part by weight of a silane coupling agent (trade name "KBM-803" manufactured by Shin-Etsu Chemical Co., Ltd., 3-mercaptopropyltrimethoxysilane) and 0.6 parts by weight of a curing agent (trade name "NY-260A" manufactured by Mitsubishi Chemical Corporation) were added and stirred for 15 minutes to give an adhesive composition.

### (11-3: Formation of Diffusion Adhesive Layer)

The adhesive composition obtained in (11-2) was applied at a thickness which gives a thickness after drying of 10 µm onto one side of a film of 100 µm thick (trade name "ZEONOR Film ZF14-100" manufactured by ZEON Corporation, refractive index 1.51), and dried at 80°C for 5 minutes to form a diffusion adhesive layer, whereby a diffusion adhesive sheet 2 having the diffusion adhesive layer was prepared.

### (11-4: Measurement of Refractive Index)

A silicone particle-free adhesive composition was produced in the same procedure as in (11-2) except that no silicone particles were added.

The silicone particle-free adhesive composition was applied at a thickness which gives a thickness after drying of 10 µm onto one side of a glass plate and dried at 80°C for 5 minutes to form an adhesive layer. The refractive index of the adhesive layer was measured with an ellipsomter (M-2000 manufactured by J. A. Woollam Japan Corporation). The results are shown in Table 3.

### (11-5: Production of Surface Light Source Device)

The diffusion adhesive sheet 2 obtained in (11-3) was attached to the surface on the side of the glass substrate of the organic EL light emitting apparatus 1. This provided a surface light source device having a layer structure of (film) / (diffusion adhesive layer) / (glass substrate) / (transparent electrode layer) / (hole transport layer) / (yellow luminescent layer) / (blue luminescent layer) / (electron transport layer) / (electron injection layer) / (reflective electrode layer) / (sealing substrate).

### <Examples 12 to 13 and Comparative Examples 4 to 7>

Diffusion adhesive sheets 2 to 7 and surface light source devices 2 to 7 were produced by performing the same procedure as in Example 11 except that the types and amounts of the reactive modified zirconia oxide slurry and the light diffusing particles used in preparation of the adhesive compositions in (11-2), the types of film used in the formation of the diffusion adhesive layer in (11-3), and the thickness of the diffusion adhesive layer formed in (11-3) were changed as shown in Table 1. In Comparative Example 4, the thickness of the diffusion adhesive layer was changed to 5 µm, and therefore the layer formation in the measurement of refractive index in (11-4) was performed so that the thickness of the adhesive layer after drying was 5 µm as well.

**Table 3**

| | Ex. 11 | Ex. 12 | Ex. 13 | Comp. Ex. 4 | Comp. Ex. 5 | Comp. Ex. 6 | Comp. Ex. 7 |
|---|---|---|---|---|---|---|---|
| Glass refractive index | 1.52 | 1.66 | 1.66 | 1.52 | 1.66 | 1.52 | 1.52 |
| ZrO₂ slurry adding amount (parts) | 75 | 188 | 150 | 188 | 188 | 150 | 75 |
| Adhesive layer refractive index | 1.55 | 1.65 | 1.6 | 1.65 | 1.65 | 1.6 | 1.55 |
| Light diffusing particles | Silicone particles A | Silicone particles B | Silicone particles A | Silicone particles C | Acrylic particles A | Titania particles | Acrylic particles B |
| Particle refractive index | 1.43 | 1.43 | 1.43 | 1.43 | 1.45 | 2.6 | 1.45 |
| Volume average particle diameter (µm) | 0.4 | 0.7 | 0.4 | 1 | 20 | 5 | 10 |
| Diffusion adhesive layer thickness (µm) | 10 | 10 | 10 | 5 | 10 | 10 | 10 |
| Substrate | ZEONOR | PET | ZEONOR | ZEONOR | PET | PET | PET |

The abbreviations in the table mean the followings.
ZrO₂ slurry: reactive modified zirconia oxide slurry (trade name "ZR-010" manufactured by Solar Co., Ltd., solvent: methyl ethyl ketone, particle content ratio 30%)
Silicone particles A: silicone particles having a volume average particle diameter of 0.4 µm (ones having a desired volume average particle diameter were selected from trade name "XC-99" manufactured by Momentive Performance Materials Inc.)
Silicone particles B: silicone particles having a volume average particle diameter of 0.7 µm (ones having a desired volume average particle diameter were selected from trade name "XC-99" manufactured by Momentive Performance Materials Inc.)
Silicone particles C: silicone particles having a volume average particle diameter of 1.0 µm (trade name "Tospearl 120" manufactured by Momentive Performance Materials Inc.)
Acrylic particles A: acrylic particles having a volume average particle diameter of 20.0 µm (trade name "MX" manufactured by Soken Chemical & Engineering Co., Ltd.)
Titania particles: titanium dioxide particles having a volume average particle diameter of 5 µm ("Titanium oxide" manufactured by Wako Pure Chemical Industries, Ltd.)
Acrylic particles B: acrylic particles having a volume average particle diameter of 10.0 µm (trade name "MX" manufactured by Soken Chemical & Engineering Co., Ltd.)
ZEONOR: trade name "ZEONOR Film ZF14-100" manufactured by ZEON Corporation, Inc., thickness 100 µm, refractive index 1.51
PET: polyethylene terephthalate film (trade name "U34" manufactured by Toray Industries, Inc., thickness 100 µm, refractive index 1.66)

### [Evaluation by Simulation]

The amount of light extraction and the chromaticity Δxy of the modeled devices of the surface light source devices 1 to 7 obtained in Examples 11 to 13 and Comparative Examples 4 to 7 were calculated by optical simulation using a program (program name: ASAP, manufactured by Breault Research).

The simulation conditions were as follows.

The modeled layered structure was, from the device light exiting surface side, a film (thickness 100 µm), a diffusion adhesive layer, a glass substrate (thickness 0.7 mm, refractive index 1.52), a transparent electrode (thickness 100 nm, refractive index 1.9), a luminescent layer (thickness 20 nm, refractive index 1.7), a reflective electrode (thickness 100 nm, refractive index 1.5, reflectance 85%), and a sealing substrate (thickness 0.7 mm, refractive index 1.52).

The refractive index of the film and the diffusion adhesive layer and the thickness of the diffusion adhesive layer were set in accordance with each of Examples and Comparative Examples.

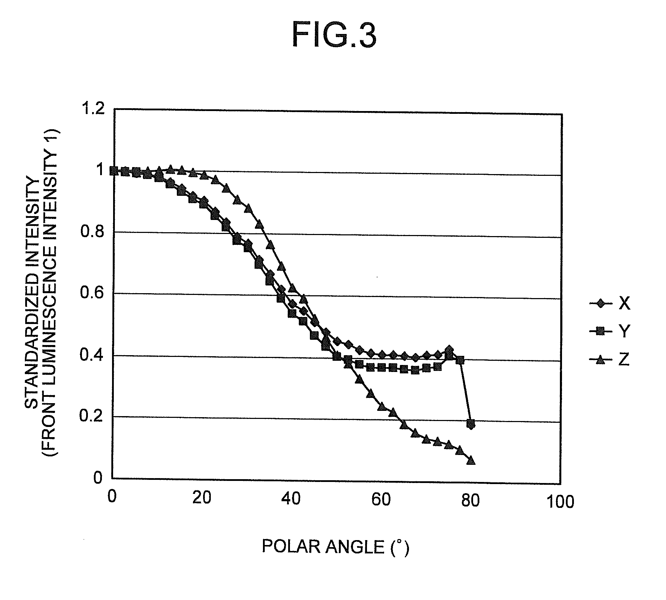

The surface of the transparent electrode on the side of the device light exiting surface was defined as a light emitting surface. The luminous intensity of the light emitting surface was set to 1 lumen. The luminous intensity distributions of the tristimulus values (XYZ) were set as shown in Fig. 3.

As the value g of the diffusion adhesive layer, the values in Table 4 calculated using the scattering phase function derived from the Mie scattering theory were used.

As the average free path of scattering in the diffusion adhesive layer, the values in Table 2 obtained from the reciprocal of the product of the particle concentration and the particle cross section were used.

By modeling in the similar conditions, the amount of light extraction when light is emitted only from the organic EL element obtained in (11-1) of Example 11 was obtained. From this value and the value of the amount of light extraction from the surface light source devices of Examples and Comparative Examples, the light extraction efficiency Q was obtained from Q = (amount of light extraction from surface light source device) / (amount of light extraction from organic EL element). Larger value of Q is indicative of better the light extraction efficiency.

The Δxy was obtained by calculating the square root of (xθ - x0)² + (yθ - y0)² from the values of xθ and yθ of the chromaticity coordinates (x, y) at given angles θ from polar angles 0° to 60° and the values of x0 and y0 of the chromaticity coordinates (x, y) at a polar angle of 0°, and finding the maximum value of the square root as the Δxy. Smaller value of the Δxy is indicative of smaller change in color tone depending on the observation angle.

The values of the light extraction efficiency Q and Δxy obtained as a result of the simulation and the values of Q × (1 - Δxy) are shown in Table 4.

**Table 4**

| | Ex. 11 | Ex. 12 | Ex. 13 | Comp. Ex. 4 | Comp. Ex. 5 | Comp. Ex. 6 | Comp. Ex. 7 |
|---|---|---|---|---|---|---|---|
| Value g | 0.8341 | 0.9356 | 0.8397 | 0.957 | 0.9943 | 0.7847 | 0.9938 |
| Average free path (µm) | 23.1 | 4.4 | 12 | 3.65 | 67.7 | 16.2 | 30.4 |
| Light extraction efficiency Q | 1.027 | 1.045 | 1.058 | 1.007 | 1.008 | 0.995 | 0.993 |
| Δxy | 0.020 | 0.019 | 0.018 | 0.022 | 0.022 | 0.022 | 0.022 |
| Q× (1-Δxy) | 1.007 | 1.025 | 1.038 | 0.985 | 0.986 | 0.973 | 0.971 |

### [Discussion]

As apparent from the results shown in Table 4, the value of Q × (1 - Δxy) was not less than 1 in Examples 11 to 13 wherein the scattering anisotropy coefficient g of the light diffusion layer and the refractive index difference between the light diffusion layer and the light-transmissive substrate were within the ranges defined in the present invention. By these results, it was confirmed that Examples 11 to 13 gave favorable surface light source devices. On the other hand, the value of Q × (1 - Δxy) was less than 1 in Comparative Example 4 wherein the refractive index difference was outside the range defined in the present application, and in Comparative Examples 5 to 7 wherein the value g was outside the range defined in the present application. This indicated that the performance of the surface light source devices was unsatisfactory.

### Reference Signs List

- 100:: Surface light source device
- 111:: Film
- 111U:: Light exiting surface
- 112:: Light diffusion layer
- 122U:: Light exiting surface
- 120:: Light exiting surface structure layer
- 121:: Light exiting surface substrate
- 122:: Concavo-convex structure layer
- 123:: Concave portion
- 124:: Flat part
- 131:: Light-transmissive substrate
- 140:: Organic EL element
- 141:: First electrode layer
- 143:: Second electrode layer
- 142:: Luminescent layer
- 151:: Sealing substrate
- 200:: Surface light source device

## Claims

1. An optical-member adhesive composition, comprising an adhesive material, reactive modified metal oxide particles having a volume average particle diameter of 1 to 500 nm, and organic light diffusing particles.

2. The optical-member adhesive composition according to claim 1, further comprising a silane coupling agent.

3. The optical-member adhesive composition according to claim 1 or 2, further comprising a plasticizer.

4. An optical-member adhesive layer formed from the optical-member adhesive composition according to any one of claims 1 to 3.

5. A surface light source device, comprising:
an organic electroluminescence element including a luminescent layer;
a light-transmissive substrate closer to a light exiting surface than the organic electroluminescence element; and
a light diffusion layer provided on a surface of the light-transmissive substrate, the surface being opposite to a surface where the organic electroluminescent element is provided, wherein
the light diffusion layer includes a light-transmissive resin and light diffusing particles, the light diffusion layer has a scattering anisotropy coefficient g of 0.83 or more and 0.97 or less, and the light diffusion layer and the light-transmissive substrate have a refractive index difference of 0.1 or less.

6. The surface light source device according to claim 5, wherein the light diffusion layer is a diffusion adhesive layer.

7. The surface light source device according to claim 5 or 6, wherein the light diffusing particles have a volume average particle diameter of 0.4 to 5 µm.

8. The surface light source device according to any one of claims 5 to 7, wherein
the light diffusion layer is formed from an optical-member adhesive composition; and
the optical-member adhesive composition contains an adhesive material as the light-transmissive resin and organic light diffusing particles as the light diffusing particles, and further contains reactive modified metal oxide particles having a volume average particle diameter of 1 to 500 nm.
